# DEMANDE DE BREVET EUROPEEN

(11) **EP 2 273 348 A1**
(43) Date de publication de la demande: **12.01.2011**
(21) Numéro de dépôt: 09165225.5
(22) Date de dépôt: 10.07.2009
(51) Int. Cl.: G06F 3/02, B29C 45/14, H03K 17/96, G04B 39/00

(54) **Procédé de fabrication d'un verre à touches capacitives pour un instrument electronique, et instrument comprenant un tel verre**

(71) Demandeur: EM Microelectronic-Marin SA, 2074 Marin (CH)
(72) Inventeur: Longa, Giovanni, 2000 Neuchâtel (CH)
(74) Mandataire: Ravenel, Thierry Gérard Louis

(57) **Abrégé**

Le procédé permet de fabriquer un verre (1) muni de touches capacitives pour un instrument électronique portable. Ce procédé comprend les étapes de placer un film isolant (3), sur lequel sont réalisées des électrodes (2) en tant que touches capacitives, des pistes conductrices (4) reliées chacune à une électrode respective et des bornes de contact externe (6) reliées chacune par l'intermédiaire des pistes conductrices aux électrodes correspondantes, dans une substance plastique transparente (5) ou semi transparente sous forme liquide à l'intérieur d'un moule. Cette substance liquide est ensuite solidifiée dans le moule, pour enrober au moins une partie du film qui comprend les électrodes, les pistes conductrices et au moins une partie des bornes de contact externe dudit film. En sortie du moule, il est obtenu un verre à touches capacitives intégrées dans ladite substance plastique solidifiée du verre.

## Description

L'invention concerne un procédé de fabrication d'un verre muni de touches capacitives pour un instrument électronique. Le verre comprend notamment un film isolant sur lequel sont réalisées des électrodes, des bornes de contact et des pistes conductrices reliant respectivement chaque électrode à une borne correspondante de contact.

L'invention concerne également un instrument électronique, qui comprend un verre à touches capacitives obtenu par le procédé de fabrication.

Il faut comprendre comme instrument électronique, tout dispositif portable, tel qu'une montre-bracelet, un téléphone portable, un badge ou un autre appareil, qui est muni d'un écran ou cadran d'affichage d'une information au-dessus duquel est disposé un verre, qui ferme le boîtier de l'instrument.

La réalisation d'un verre muni d'une ou plusieurs électrodes transparentes en tant que touches capacitives pour équiper un instrument électronique est bien connue notamment dans le domaine de l'horlogerie ou des téléphones portables. On peut citer à ce titre le document de brevet EP 0 674 247, qui décrit justement une montre qui comprend un dispositif de commande manuelle. La montre décrite comporte un boîtier métallique formant masse, un verre et un dispositif de commande manuelle comprenant au moins une électrode en tant que touche capacitive, placée sur la face intérieure du verre. Cette touche capacitive peut être considérée comme activée en liaison avec un circuit de traitement dans la montre, au moyen d'un doigt du porteur de la montre, qui est placé en regard de l'électrode sur la face extérieure du verre. Ceci permet de former une capacité totale entre le doigt et l'électrode, ainsi qu'entre l'électrode et la masse constituée par le boîtier métallique de la montre. Le circuit de traitement dans la montre comprend aussi un convertisseur tension-fréquence, dont la fréquence d'oscillation est déterminée par la valeur de la capacité mentionnée ci-dessus. L'électrode transparente est donc reliée de manière bien connue par un conducteur au convertisseur qui est logé dans le boîtier.

Habituellement plusieurs électrodes transparentes, qui constituent des touches capacitives sont disposées sur la face intérieure du verre de l'instrument électronique, tel qu'une montre-bracelet. Le clavier de touches capacitives ainsi formé peut être destiné à remplacer les moyens de commande externes habituels tels que des boutons-poussoirs utilisés pour commander les diverses fonctions d'un instrument électronique. La réalisation de telles électrodes transparentes sur la face intérieure du verre est effectuée par un dépôt d'une couche d'oxyde conducteur, qui peut être conventionnellement un oxyde d'étain et d'indium (ITO), et par une gravure chimique de cette couche d'oxyde conducteur. La couche d'oxyde conducteur est déposée par évaporation sur une épaisseur comprise généralement entre 25 et 75 nm, et de préférence entre 45 et 55 nm. Chaque électrode transparente est reliée par une piste conductrice jusqu'à une zone de contacts en bordure du verre de l'instrument électronique de manière à être reliée par l'intermédiaire d'un connecteur au circuit de traitement dans l'instrument électronique.

Dans d'autres réalisations d'instrument électronique muni d'un verre à touches capacitives, le boîtier de l'instrument, ainsi que le verre ou glace, peuvent être faits en matière plastique. Le verre en matière plastique notamment pour un instrument électronique, tel qu'une montre-bracelet, doit avoir une épaisseur suffisante, d'une part pour résister aux chocs d'agents extérieurs et d'autre part pour supporter une certaine pression hydrostatique lorsque cette montre est immergée. Le verre doit pouvoir supporter une pression qui peut être de l'ordre de 3 bars. Cette forte épaisseur du verre peut ainsi nuire au bon fonctionnement du clavier à touches capacitives disposées sur la face intérieure du verre. En effet, un verre épais conduit à un diélectrique important interposé entre les électrodes des touches capacitives et le doigt de l'utilisateur posé en regard d'au moins une des électrodes à activer, ce qui est généralement un inconvénient de tels verres à touches capacitives.

On peut citer également le document de brevet EP 1 544 178, qui décrit un procédé de fabrication d'électrodes transparentes d'un écran tactile. Un réseau conducteur d'une couche d'oxyde du type ITO est formé sur une face intérieure d'un substrat transparent formant par exemple un verre de montre. Ce réseau conducteur comprend les électrodes transparentes et les pistes conductrices qui relient respectivement les électrodes à une zone de contacts en bordure du substrat. Cette couche structurée d'oxyde conducteur est recouverte encore de deux couches de diélectriques à indice de réfraction différent pour rendre invisibles les électrodes. Cependant comme précédemment décrit, le substrat transparent doit généralement être d'une forte épaisseur. Cela nuit au bon fonctionnement des touches capacitives réalisées sur la face intérieure du substrat, en liaison à un circuit de traitement d'un instrument électronique, ce qui est un inconvénient.

Dans le cas d'une montre à affichage de l'heure numériquement, des touches capacitives peuvent être réalisées dans le dispositif d'affichage à cristaux liquides. Cependant comme le boîtier d'une telle montre est fermée par un verre supplémentaire au dispositif d'affichage à cristaux liquides, une distance relativement élevée subsiste entre le doigt d'un utilisateur posé sur la face extérieure du verre et une électrode d'une touche capacitive à activer. Ceci constitue également un inconvénient.

L'invention a donc pour but de pallier aux inconvénients de l'état de la technique en fournissant un procédé de fabrication d'un verre à touches capacitives pour un instrument électronique portable, qui soit suffisamment résistant tout en garantissant une grande sensibilité d'actions des touches capacitives activées notamment par un doigt d'un utilisateur.

A cet effet, l'invention concerne un procédé de fabrication d'un verre à touches capacitives pour un instrument électronique portable cité ci-devant qui comprend les caractéristiques définies dans la revendication indépendante 1.

Des étapes particulières du procédé de fabrication sont définies dans les revendications dépendantes 2 à 11.

Un avantage du procédé de fabrication d'un verre à touches capacitives selon l'invention réside dans le fait que les électrodes des touches capacitives sont moulées dans le matériau constituant le verre de l'instrument électronique. Même si ce verre est réalisé relativement épais pour résister aux chocs d'agents extérieurs et pour supporter une certaine pression hydrostatique, une bonne sensibilité des touches capacitives est garantie. Pour ce faire, les électrodes réalisées sur un film isolant transparent peuvent être situées par exemple à mi-hauteur de l'épaisseur du verre après l'opération de moulage. Ceci améliore la sensibilité de ces touches capacitives intégrées dans le verre par rapport aux verres à touches capacitives de l'état de la technique, car la sensibilité est inversement proportionnelle à la distance entre les électrodes et la surface de contact du verre.

A cet effet, l'invention concerne également un instrument électronique, tel qu'une montre-bracelet, qui comprend un verre à touches capacitives obtenu par le procédé de fabrication.

Les buts, avantages et caractéristiques du procédé de fabrication d'un verre à touches capacitives pour un instrument électronique portable, et de l'instrument le comprenant apparaîtront mieux dans la description suivante sur la base de formes d'exécution non limitatives illustrées par les dessins sur lesquels :
les figures 1a et 1b représentent une vue de dessus et en coupe selon I-I de la figure 1a d'une première forme d'exécution du verre à touches capacitives obtenu par le procédé de fabrication selon l'invention,
la figure 2 représente une vue en coupe selon I-I de la figure 1a d'une seconde forme d'exécution du verre à touches capacitives obtenu par le procédé de fabrication selon l'invention,
la figure 3 représente une vue en coupe selon I-I de la figure 1a d'une troisième forme d'exécution du verre à touches capacitives obtenu par le procédé de fabrication selon l'invention,
la figure 4 représente une vue en coupe selon I-I de la figure 1a d'une quatrième forme d'exécution du verre à touches capacitives obtenu par le procédé de fabrication selon l'invention,
la figure 5 représente une vue en coupe selon I-I de la figure 1a d'une cinquième forme d'exécution du verre à touches capacitives obtenu par le procédé de fabrication selon l'invention, et
la figure 6 représente une vue partielle en coupe d'une montre comprenant un verre à touches capacitives de la seconde forme d'exécution selon l'invention.

Dans la description suivante, tous les éléments qui constituent le verre à touches capacitives pour un instrument électronique portable qui sont bien connus de l'homme du métier dans ce domaine technique ne seront relatés que de manière simplifiée. Il est fait référence principalement à un verre à touches capacitives destiné à équiper une montre-bracelet en tant qu'instrument électronique portable. Toutefois un tel verre à touches capacitives peut être fabriqué pour être utilisé également dans différents autres instruments électroniques.

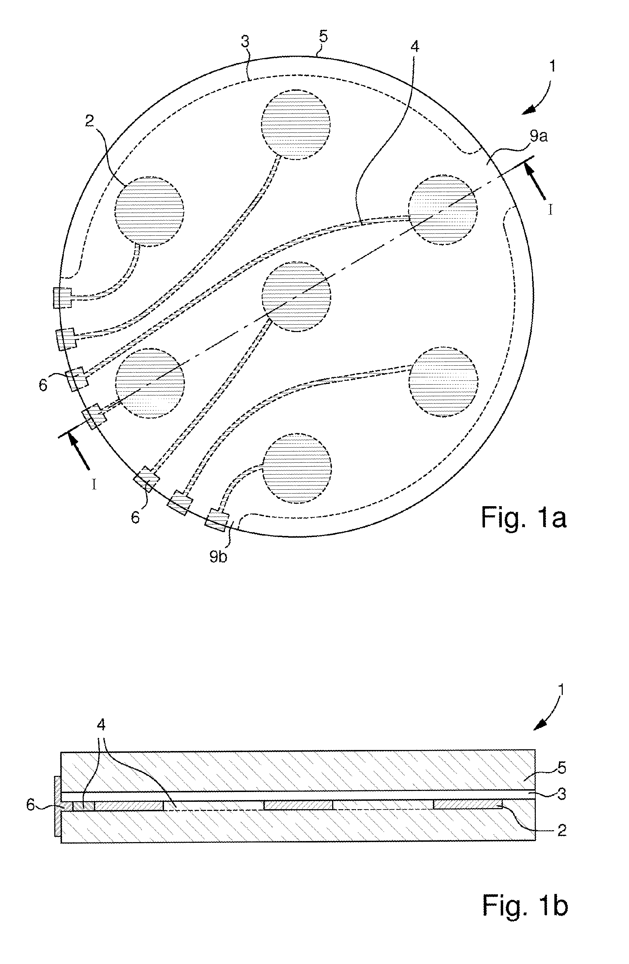

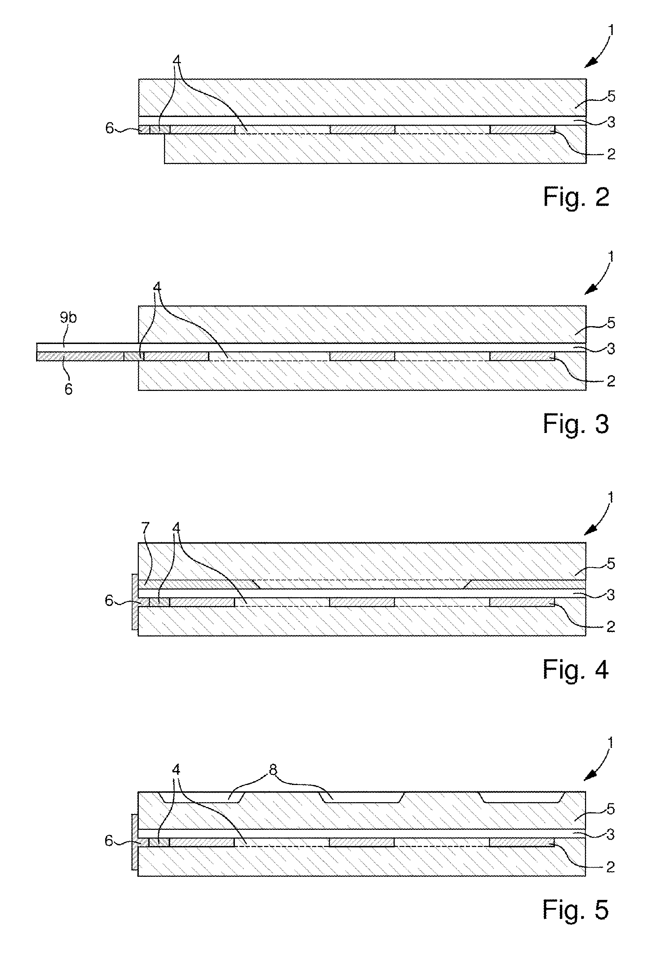

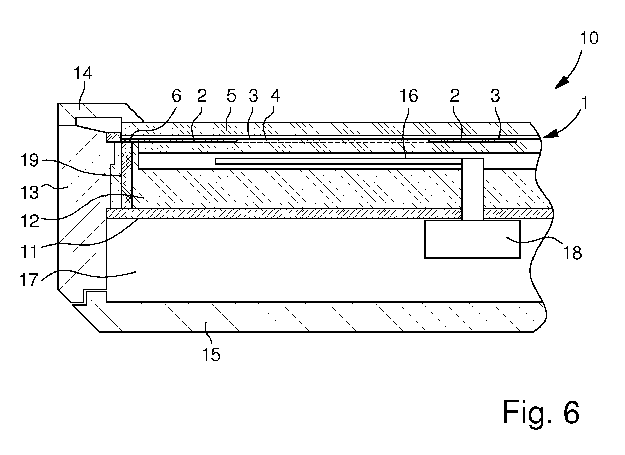

Aux figures 1a et 1b, il est représenté une vue de dessus et en coupe diamétrale d'une première forme d'exécution d'un verre à touches capacitives obtenu par le procédé de fabrication selon l'invention. Le verre 1 peut être de forme circulaire comme représenté à la figure 1a, mais également de forme rectangulaire ou d'une autre forme. Il peut être de forme générale plane comme montré à la figure 1b, mais également de forme bombée non représentée. Ce verre à touches capacitives peut être fabriqué notamment pour équiper une montre du type montre-bracelet discuté ci-après en référence à la figure 6. Sur ces figures 1a et 1b, ainsi que sur les figures 2 à 6, les différents contrastes et épaisseurs des éléments représentés ont été quelque peu exagérés de manière à fournir une meilleure compréhension de l'invention.

Le verre 1 comprend tout d'abord un film isolant 3 sur lequel sont réalisées des électrodes transparentes 2, des pistes conductrices transparentes 4 et des bornes de contact externe 6 d'une zone de contacts. Chaque électrode transparente 2 est reliée par l'intermédiaire d'une piste conductrice 4 respective à une borne de contact 6 de la zone de contacts également transparents. La zone de contacts 6 se trouve de préférence en bordure du verre 1. Les électrodes 2, les pistes conductrices 4, ainsi que les bornes de contact 6 sont obtenues de manière bien connue suite à une gravure chimique d'une couche conductrice d'oxyde d'étain et d'indium (ITO) préalablement déposée sur le film isolant. L'épaisseur de cette couche ITO peut être entre 25 et 75 nm et de préférence entre 45 et 55 nm. L'épaisseur du film isolant peut être équivalente à celle de la couche ITO.

Comme montré à la figure 1a, les électrodes transparentes 2 agissant comme touches capacitives, sont en nombre de sept suffisamment espacées les unes des autres de manière à permettre l'activation d'une seule touche capacitive par un doigt posé sur la surface extérieure de contact du verre. Bien entendu, il pourrait être envisagé d'en réaliser un plus grand nombre ou un nombre plus restreint dans le verre 1 selon l'instrument électronique, qui comprend un tel verre pour accomplir des fonctions spécifiques souhaitées. Lesdites électrodes transparentes 2 peuvent également être de diverses autres formes que celle représentée à la figure 1a, et disposées en périphérie du verre ou sur toute la surface intérieure du verre 1.

Une fois que le film à électrodes transparentes 2, à pistes conductrices 4 et à zone de contacts 6 est réalisé, ce film est disposé dans un moule non représenté pour une opération de moulage du verre de montre. La forme intérieure de ce moule correspond de manière générale la forme du verre à obtenir. Le film 3 peut comprendre des portions 9a et 9b, qui sont initialement d'une longueur déterminée plus grande que celles représentées à la figure 1a, de manière à permettre de maintenir le film à électrodes 2 dans le moule. Les deux portions 9a et 9b sont par exemple pincées en fermant les deux parties constituant ledit moule.

Après fermeture du moule et maintien du film 3 à électrodes transparentes 2 à l'intérieur du moule, une substance plastique chauffée sous forme liquide est introduite par au moins une ouverture du moule afin de le remplir et d'enrober une partie du film à électrodes. Une opération de solidification de la substance plastique est ensuite effectuée et le verre ainsi obtenu est sorti du moule. Une opération d'ébavurage est encore entreprise pour terminer la forme finale du verre. Finalement, les deux portions 9a et 9b sont découpées à fleur du bord du verre 1 ainsi obtenu en laissant la possibilité de venir connecter les bornes de contact externe 6 directement sur la surface latérale du verre 1.

Il peut être encore réalisé des portions conductrices complémentaires de connexion au niveau de la zone de contacts 6 sur une partie de la surface latérale du verre. Ceci permet de faciliter la connexion des électrodes transparentes 2 par l'intermédiaire d'un connecteur électrique, à un circuit de traitement dans l'instrument électronique. Les bornes de contact externe 6 de la zone de contacts peuvent aussi être réalisées dans un autre matériau que l'oxyde ITO, par exemple en métal. Cela permet de réaliser des portions conductrices complémentaires également dans un matériau métallique, qui facilite la connexion par l'intermédiaire du connecteur électrique.

Lors de l'opération de moulage, il peut aussi être imaginé d'injecter dans le moule une substance plastique, voire d'une autre matière transparente, sous la forme de poudre, et ensuite de chauffer ledit moule pour rendre liquide ladite substance enrobant le film 3 à électrodes. Il peut aussi être imaginé de placer tout d'abord le film isolant muni des électrodes transparentes 2 dans un bain de substance plastique liquide et de venir enfermer par la suite le film dans le moule trempé dans la substance plastique liquide. Finalement, cette substance liquide enrobant le film est solidifiée dans le moule et le verre terminé est sorti du moule.

Pour une telle réalisation du verre de montre à touches capacitives intégrées, il peut être utilisé une technique définie sous la dénomination anglaise In-Mould Decoration (IMD), ou encore une technique définie sous la dénomination anglaise Film Insert Moudling (FIM) ou d'autres techniques. Dans la technique FIM, le film 3 à électrodes transparentes 2 peut être intégré dans la substance liquide avant solidification.

A la figure 2, il est représenté une coupe diamétrale d'une seconde forme d'exécution du verre 1 à touches capacitives obtenu par le procédé de fabrication selon l'invention, pour un instrument électronique. Il est à noter que tous les mêmes éléments du verre 1 décrits à la figure 2 portent des signes de référence identiques à ceux représentés aux figures 1a et 1 b. De ce fait par simplification, il ne sera pas répété la description de chacun de ces mêmes éléments.

L'unique différence de cette seconde forme d'exécution du verre à touches capacitives réside dans le fait qu'après l'opération de moulage à la sortie du moule, la substance plastique solidifiée constituant le verre ne recouvre pas au moins une face de dessous des bornes de contact externe 6 et une partie des pistes conductrices 4. Ceci permet de pouvoir connecter directement ces bornes de contact externe 6 sur un connecteur électrique.

Il aurait également pu être imaginé de réaliser une opération de moulage du film comme pour la première forme d'exécution, et ensuite effectuer une opération de fraisage depuis le bord du verre du côté de la zone de contacts 6. Cette opération de fraisage d'une partie inférieure du matériau 5 constituant le verre de montre, permet de dégager depuis dessous les bornes de contact externe 6 de la zone de contacts et une portion des pistes conductrices 4. Grâce à cette opération de fraisage, il est possible de venir connecter directement la zone de contacts sur un connecteur électrique relié au circuit de traitement de l'instrument électronique comme montré à la figure 6 expliquée ci-après.

A la figure 3, il est représenté une coupe diamétrale d'une troisième forme d'exécution du verre 1 à touches capacitives obtenu par le procédé de fabrication selon l'invention, pour un instrument électronique. Il est à noter que tous les mêmes éléments du verre 1 décrits à la figure 3 portent des signes de référence identiques à ceux représentés aux figures 1a, 1b et 2. De ce fait par simplification, il ne sera pas répété la description de chacun de ces mêmes éléments.

Les bornes de contact externe 6 se trouvent sur une des deux portions 9a et 9b du film, qui sont pincées dans le moule pour l'opération de moulage. Il peut donc être envisagé de maintenir toute la zone de contacts 6 et une partie des pistes conductrices 4 du côté de la portion 9b pincées par les deux parties du moule en position de fermeture. Cela permet d'obtenir un verre en sortie du moule, qui comprend une partie du film isolant flexible avec les bornes de contact 6 découvertes débouchant de la surface latérale du verre 1. Cette partie du film non représentée peut servir directement comme pour une connexion par câble.

Les bornes de contact 6 peuvent être réalisées par une technique de sérigraphie d'une pâte ayant des particules métalliques sur le film isolant 3. Il peut s'agir d'une pâte d'argent, de graphite ou d'un autre matériau.

A la figure 4, il est représenté une coupe diamétrale d'une quatrième forme d'exécution du verre 1 à touches capacitives obtenu par le procédé de fabrication selon l'invention, pour un instrument électronique. Il est à noter que tous les mêmes éléments du verre 1 décrits à la figure 4 portent des signes de référence identiques à ceux représentés aux figures 1a, 1b, 2 et 3. De ce fait par simplification, il ne sera pas répété la description de chacun de ces mêmes éléments.

Il est prévu dans cette quatrième forme d'exécution du verre à touches capacitives de réaliser une couche décorative 7 au-dessus du film et en partie au-dessus des électrodes transparentes 2. Lorsque le verre 1 équipe un instrument électronique, cette couche décorative 7, qui peut être opaque ou semi-transparente, permet notamment de cacher la vision de la zone de contacts 6 pour un utilisateur de l'instrument.

La couche décorative 7 peut être réalisée sur le film isolant 3 avant ou après la structuration par gravure chimique de la couche conductrice d'oxyde ITO. Une fois que la couche conductrice structurée et la couche décorative sur le film sont réalisées, il peut être entrepris l'opération de moulage du verre 1 dans un moule prévu à cet effet comme indiqué ci-dessus en référence à la figure 1b. La substance plastique liquide enrobe la film 3 et une solidification de cette substance dans le moule est opérée afin que le verre ainsi obtenu ait le film à électrodes et la couche décorative intégré dans la substance plastique transparente solide du verre 1.

Comme en référence à la première forme d'exécution du verre de la figure 1b, il peut être prévu de réaliser des portions conductrices complémentaires de connexion au niveau de la zone de contacts 6 sur une partie de la surface latérale ébavurée du verre. Ces portions conductrices facilitent la connexion des électrodes transparentes 2 par l'intermédiaire d'un connecteur électrique, à un circuit de traitement dans l'instrument électronique. Cependant, il peut être envisagé également que la surface intérieure du moule est configurée de telle manière qu'au moins les bornes de contact 6 ne sont pas recouvertes par la substance plastique solidifiée en sortie du moule comme pour la seconde forme d'exécution. Il peut aussi être envisagé d'avoir une partie du film flexible 3 débouchant de la surface latérale du verre avec les bornes de contact 6 directement accessibles sur la portion 9b du film comme pour la troisième forme d'exécution.

Il est à noter qu'une ou plusieurs couches décoratives 7 peuvent être déposées sur le film isolant 3. La ou les couches décoratives peuvent porter des indications chiffrées ou des symboles ou au moins une image. De plus, une telle couche décorative 7 peut être appliquée également à la seconde forme d'exécution du verre 1 à touches capacitives représentée à la figure 2. Ceci permet de bien cacher la zone de contacts et sa liaison à un connecteur du type Zebra de l'instrument électronique, qui comprend un tel verre.

La figure 5 représente une coupe diamétrale d'une cinquième forme d'exécution du verre 1 à touches capacitives obtenu par le procédé de fabrication selon l'invention, pour un instrument électronique, tel qu'une montre-bracelet. Il est à noter que tous les mêmes éléments du verre 1 décrits à la figure 5 portent des signes de référence identiques à ceux représentés aux figures 1a, 1b, 2, 3 et 4. De ce fait par simplification, il ne sera pas répété la description de chacun de ces mêmes éléments.

Cette cinquième forme d'exécution du verre est très similaire à la première forme d'exécution du verre de la figure 1 b. La seule différence est le fait qu'il est réalisé des amincissements 8 de l'épaisseur du verre depuis une surface de contact pour un doigt d'un utilisateur, uniquement au-dessus des électrodes transparentes 2. Ces amincissements 8, qui peuvent être en nombre équivalent au nombre d'électrodes prévues, permettent de réduire localement la distance entre chaque électrode transparente et le doigt en contact du verre dans chaque amincissement 8. Ceci permet d'améliorer la sensibilité d'action des touches capacitives par cette réduction d'épaisseur locale tout en conservant une bonne résistance générale du verre à diverses contraintes externes. Grâce à ces amincissements 8 en épaisseur du verre, il peut être envisagé de réduire la surface de chaque électrode tout en ayant une sensibilité équivalente à celle des autres formes d'exécution décrites ci-devant.

Les amincissements 8 de l'épaisseur de verre peuvent être réalisés pendant l'opération de moulage du verre ou après l'opération de moulage du verre de préférence au terme de toutes les étapes du procédé de fabrication décrites ci-devant. Comme il peut être prévu de réaliser sept électrodes transparentes, il doit être réalisé par moulage ou fraisage sept amincissements 8 de l'épaisseur du verre de diamètre légèrement supérieur au diamètre de chaque électrode ou de dimension légèrement supérieure si chaque électrode est de forme autre que circulaire.

A la figure 6, il est représenté une coupe partielle d'une montre 10 qui comprend un verre 1 à touches capacitives notamment selon la seconde forme d'exécution.

La montre-bracelet 10 représentée comporte de façon connue un boîtier qui est formé d'une carrure 13 fermée à sa partie inférieure par un fond 15 et à sa partie supérieure par un verre 1 délimitant un compartiment 17. Le compartiment 17 permet de loger un mouvement horloger 18 schématiquement représenté, permettant l'affichage d'informations horaires sur un cadran 12 au moyen d'aiguilles 16. Il peut être prévu également une lunette 14 sur la carrure 13, qui recouvre une partie du verre afin de cacher la zone de contacts 6 du verre à touches capacitives 1.

On voit également que le verre 1 de la montre comporte des électrodes transparentes 2 intégrées dans le matériau plastique 5 du verre. Lesdites électrodes 2 sont chacune reliée par des pistes conductrices 4 à des bornes de contact externe 6 d'une zone de contacts située près du bord du verre. Comme indiqué précédemment, les électrodes, les pistes conductrices et les bornes de contact sont réalisées de façon connue sur un film isolant 3 par structuration d'un oxyde conducteur transparent, tel que l'oxyde d'étain et d'indium (ITO) avant l'opération de moulage. Les électrodes 2 et les pistes conductrices 4 peuvent être rendues pratiquement invisibles en déposant des couches diélectriques de compensation non représentées dans les espaces compris entre lesdites électrodes 2 et les pistes 4, comme décrit par exemple dans le document de brevet EP 1 457 865.

Les bornes de contact 6 du verre, qui relient via les pistes conductrices, les électrodes transparentes 2, sont connectées directement sur un connecteur du type Zebra 19, qui traverse le cadran 12. Ce connecteur Zebra 19 est fixé sur une plaque à circuit imprimé 11 placée au dos du cadran. Le connecteur 19 est relié à un circuit intégré non représenté qui comprend notamment le circuit de traitement des actions des touches capacitives, ce qui est bien connu.

Il est à noter que la montre-bracelet 10 peut être équipée d'une autre forme d'exécution du verre 1 à touches capacitives obtenu par le procédé de fabrication. Il peut être envisagé d'intégrer également au moins une couche décorative dans le matériau plastique du verre comme représenté à la figure 4 tout en conservant le verre avec des bornes de contact 6 découvertes comme représentées aux figures 2 et 3. De plus, il peut également être prévu en plus de la couche décorative d'amincir localement le verre du côté de la surface de contact et directement au-dessus des électrodes transparentes comme indiqué en référence à la figure 5.

A partir de la description qui vient d'être faite, plusieurs variantes du procédé de fabrication du verre à touches capacitives, et du verre ainsi obtenu peuvent être conçues par l'homme du métier sans sortir du cadre de l'invention définie par les revendications. Il peut être prévu de placer les électrodes transparentes à mi-hauteur de l'épaisseur du verre sur une face de dessus du film isolant en regard de la surface de contact du verre pour un doigt d'un utilisateur. Il aurait pu être envisagé de réaliser les électrodes transparentes dans des ouvertures pratiquées dans le film isolant support pour limiter l'épaisseur de cet ensemble avant l'opération de moulage du film dans un matériau plastique. Il peut être également envisagé d'enrober dans un matériau plastique intégralement le film isolant avec les électrodes, les pistes conductrices et les bornes de contact, et ensuite de fraiser une partie du verre au niveau des bornes de contact externe pour les découvrir. La substance plastique utilisée pour former le verre à touches capacitives intégrées peut être aussi semi-transparente et colorée. Le film isolant peut être prévu pour comprendre plusieurs ensembles d'électrodes, pistes conductrices et bornes de contact de manière à réaliser plusieurs verres en même temps dans un moule à plusieurs compartiments.

## Revendications

1. Procédé de fabrication d'un verre (1) muni de touches capacitives pour un instrument électronique portable (10), **caractérisé en ce qu'**il comprend des étapes consistant à :
- placer un film isolant (3), sur lequel sont réalisées des électrodes (2) en tant que touches capacitives, des pistes conductrices (4) reliées chacune à une électrode respective et des bornes de contact externe (6) reliées chacune par l'intermédiaire des pistes conductrices aux électrodes correspondantes, dans une substance plastique transparente (5) ou semi transparente sous forme liquide à l'intérieur d'un moule, et
- solidifier dans le moule, la substance plastique liquide, qui enrobe au moins une partie du film qui comprend les électrodes, les pistes conductrices et au moins une partie des bornes de contact externe dudit film pour obtenir le verre à touches capacitives intégrées dans ladite substance plastique solidifiée du verre.

2. Procédé de fabrication d'un verre (1) selon la revendication 1, **caractérisé en ce que** le film isolant (3) avec les électrodes (2), les pistes conductrices (4) et les bornes de contact externe (6) sont disposés tout d'abord dans le moule, **en ce que** la substance plastique liquide (5) est ensuite introduite par au moins une ouverture dans le moule, dont la surface intérieure correspond à la forme générale du verre à obtenir, pour placer au moins une partie du film dans ladite substance plastique liquide, et **en ce qu'**une fois que le moule est rempli de la substance plastique liquide, une solidification de ladite substance plastique est effectuée pour obtenir le verre à touches capacitives intégrées dans ladite substance plastique solidifiée du verre.

3. Procédé de fabrication d'un verre (1) selon la revendication 1, **caractérisé en ce que** le film isolant (3) avec les électrodes (2), les pistes conductrices (4) et les bornes de contact externe (6) sont disposés tout d'abord dans le moule, **en ce qu'**une substance plastique (5) sous forme de poudre est ensuite introduite par au moins une ouverture dans le moule pour le remplir, **en ce que** le moule est chauffé pour liquéfier ladite substance plastique, qui occupe tout le volume intérieur du moule, pour placer au moins une partie du film dans ladite substance plastique liquide, et **en ce qu'**une solidification de ladite substance plastique liquide est effectuée pour obtenir le verre à touches capacitives intégrées dans ladite substance plastique solidifiée du verre en sortie du moule.

4. Procédé de fabrication d'un verre (1) selon l'une des revendications précédentes, **caractérisé en ce qu'**en plaçant le film isolant transparent (3) avec les électrodes transparentes (2), les pistes conductrices transparentes (4) et les bornes de contact externe (6) dans le moule, qui comprend deux parties, au moins deux portions (9a, 9b) du film isolant sont pincées par les deux parties du moule en position de fermeture pour maintenir le film dans une position déterminée à l'intérieur du moule avant d'introduire la substance plastique liquide ou en poudre par au moins une ouverture du moule.

5. Procédé de fabrication d'un verre (1) selon la revendication 4, **caractérisé en ce que** les portions (9a, 9b) du film (3) non recouvertes par la substance plastique solidifiée dans le moule, sont découpées en dehors du moule en donnant accès aux bornes de contact externe (6) sur la surface latérale du verre.

6. Procédé de fabrication d'un verre (1) selon la revendication 5, **caractérisé en ce qu'**en sortie du moule et après découpage des portions du film non recouvertes, il est réalisé des portions conductrices complémentaires aux bornes de contact externe (6), ces portions complémentaires s'étendant en partie sur la surface latérale du verre.

7. Procédé de fabrication d'un verre (1) selon la revendication 4, **caractérisé en ce qu'**une des portions du film flexible, qui sont pincées par les deux parties du moule en position de fermeture, porte toutes les bornes de contact externe (6) et une partie des pistes conductrices, et **en ce que** la substance plastique liquide est solidifiée dans le moule sans recouvrir la portion du film flexible portant lesdites bornes de contact afin d'obtenir un verre avec une partie du film isolant flexible (3) avec les bornes de contact (6) découvertes débouchant de la surface latérale du verre.

8. Procédé de fabrication d'un verre (1) selon la revendication 1, **caractérisé en ce que** le film est placé dans le moule de manière qu'au moins une face inférieure des bornes de contact externe (6) en bordure du verre et une partie des pistes conductrices (4) n'est pas recouverte par la substance plastique solidifiée du verre en sortie du moule.

9. Procédé de fabrication d'un verre (1) selon la revendication 1, **caractérisé en ce qu'**initialement, une couche conductrice transparente d'oxyde d'étain et d'indium est déposée sur une face du film isolant (3), et **en ce qu'**une gravure chimique sélective de ladite couche d'oxyde est effectuée pour obtenir les électrodes transparentes (2), les pistes conductrices transparentes (4) et les bornes de contact externe (6) avant de placer le film dans la substance liquide dans le moule.

10. Procédé de fabrication d'un verre (1) selon la revendication 9, **caractérisé en ce qu'**au moins une couche décorative (7) est réalisée sur une face du film en partie au-dessus des électrodes (2), des pistes conductrices (4) et des bornes de contact (6) par rapport à une surface supérieure de contact du verre par un doigt d'un utilisateur, **en ce que** le film est ensuite placé dans la substance liquide dans le moule, et **en ce que** la substance liquide est solidifiée dans le moule pour obtenir le verre à touches capacitives et à couche décorative intégrées dans la substance liquide solidifiée, la couche décorative disposée entre la face du film portant les électrodes, les pistes conductrices et les bornes de contact, et la surface de contact du verre, permettant de cacher au moins les bornes de contact externe disposées en bordure du verre.

11. Procédé de fabrication d'un verre (1) selon l'une des revendications précédentes, **caractérisé en ce que** la surface intérieure du moule est formée de telle manière qu'après l'opération de solidification de la substance plastique sur au moins une partie du film, des amincissements (8) d'épaisseur du verre depuis la surface de contact sont réalisés au-dessus des électrodes transparentes.

12. Instrument électronique portable (10) comprenant un verre (1) à touches capacitives obtenu par le procédé de fabrication selon l'une des revendications précédentes, et un circuit de traitement, qui est relié par l'intermédiaire d'un connecteur aux bornes de contact externe (6) du verre.
